# EUROPEAN PATENT APPLICATION

(11) **EP 4 468 342 A1**
(43) Date of publication of application: **27.11.2024**
(21) Application number: 23386041.0
(22) Date of filing: 25.05.2023
(51) Int. Cl.: H01L 23/498, H01L 23/66

(54) **INTEGRATED CIRCUIT PACKAGE**

(71) Applicant: NXP B.V., 5656 AG Eindhoven (NL)
(72) Inventor: Van Schelven, Ralph Matthijs, 5656 AG Eindhoven (NL); Syed, Waqas Hassan, 5656 AG Eindhoven (NL); Doris, Konstantinos, 5656 AG Eindhoven (NL); Tiemeijer, Lukas Frederik, 5656 AG Eindhoven (NL); Montoriol, Gilles, 5656 AG Eindhoven (NL); Auvray, Francis Jean Guy, 5656 AG Eindhoven (NL)
(74) Representative: Krott, Michel

(57) **Abstract**

A package for an integrated circuit, IC, the package comprising an interposer comprising: a first metal layer including a first metal plate; a second metal layer including a second metal plate; and a dielectric layer separating the first metal layer and the second metal layer, wherein the first metal plate and the second metal plate are arranged to form a parallel plate waveguide, PPW, and wherein the first metal plate comprises a slot for receiving one or more differential signals from the 1C.

## Description

### Field

The present disclosure relates to a package for an integrated circuit.

### Summary

According to a first aspect of the present disclosure there is provided a package for an integrated circuit, IC, the package comprising an interposer comprising:
a first metal layer including a first metal plate;
a second metal layer including a second metal plate; and
a dielectric layer separating the first metal layer and the second metal layer,
wherein the first metal plate and the second metal plate are arranged to form a parallel plate waveguide, PPW, and wherein the first metal plate comprises a slot for receiving one or more differential signals from the IC.

In one or more embodiments, the PPW may be configured to combine the one or more differential signals and provide an output signal.

In one or more embodiments, the output signal may comprise a single-ended output signal. The package may comprise an output port for coupling the single-ended output signal to a printed circuit board, PCB. The output port may comprise a microstrip or a grounded co-planar waveguide for coupling to the PCB by a package-to-PCB interface.

In one or more embodiments, each differential signal may comprise a first component and a second component. The first component may comprise a first voltage component and the second component may comprise a second voltage component. The first voltage component may comprise a positive voltage component and the second voltage component may comprise a negative voltage component.

In one or more embodiments, the PPW may provide an in-package power combiner for combining a first differential signal and a second differential signal.

In one or more embodiments, the package may further comprise one or more differential feeds for receiving a respective one of the one or more differential signals. Each differential feed may be arranged to excite the slot and the PPW in response to receiving the respective differential signal.

In one or more embodiments, the one or more differential feeds may comprise a plurality of differential feeds spaced apart along a length of the slot.

In one or more embodiments, the one or more differential feeds may form part of an IC-to-package transition connection.

In one or more embodiments, each differential feed may comprise:
a first die-to-package signal connector arranged on the first plate on a first side of the slot; and
a second die-to-package signal connector arranged on the first plate on a second side of the slot opposite the first side.

In one or more embodiments, the first die-to-package signal connector of each differential feed may be coupled to a respective first IO port of the IC for receiving a first component of the respective differential signal. The second die-to-package signal connector of each differential feed may be coupled to a respective second IO port of the IC for receiving a second component of the respective differential signal.

In one or more embodiments, the package may comprise a plurality of first and second die-to-package signal connectors arranged along a length of the slot.

In one or more embodiments, the plurality of first and second die-to-package signal connectors may be arranged periodically along the length of the slot. The plurality of first and second die-to-package signal connectors may be coupled to respective first and second IO ports of the IC for receiving respective first and second components of a respective differential signal from a respective power amplifier.

In one or more embodiments, the package may comprise:
a first die-to-package grounded connector arranged on the first metal plate on the first side of the slot, wherein a first die-to-package signal connector of a first differential feed is arranged between the first die-to-package grounded connector and the slot; and
a second die-to-package grounded connector arranged on the first metal plate on the second side of the slot, wherein the second die-to-package signal connector of the first differential feed is arranged between the second die-to-package grounded connector and the slot.

In one or more embodiments, the first die-to-package grounded connector and the second die-to-package connector may form part of an IC-to-package transition connection.

In one or more embodiments, the package may comprise a plurality of die-to-package grounded connectors arranged further from the slot than the one or more differential feeds.

In one or more embodiments, the PPW may extend in a propagation direction from the slot to an output port of the PPW. The slot may extend in a transverse direction perpendicular to the propagation direction.

In one or more embodiments, the slot may traverse the first metal plate with a meandering shape.

In one or more embodiments, the PPW may extend in a propagation direction from the slot to an output port of the PPW and the slot may comprise:
a first portion extending in a transverse direction, perpendicular to the propagation direction, at a first position with respect to the propagation direction;
a second portion extending in the transverse direction at a second position with respect to the propagation direction, wherein the second position is offset from the first position;
a third portion extending in the propagation direction and connecting the first portion and the second portion.

In one or more embodiments, the package may further comprise:
a first differential feed for receiving a first differential signal of the one or more differential signals, wherein the first differential feed is arranged on either side of the first portion of the slot;
a second differential feed for receiving a second differential signal of the one or more differential signals, wherein the second differential feed is arranged on either side of the second portion of the slot.

In one or more embodiments, a non-propagating end of the PPW may comprise an open-ended stub or a short circuit connection.

In one or more embodiments, a distance from the slot to the open-ended stub may comprise a quarter wavelength of a centre-operating wavelength of the package.

In one or more embodiments, the package may comprise an impedance transformer extending between the PPW and an output port of the package.

In one or more embodiments, the impedance transformer may be realised in the first metal layer or the second metal layer. The impedance transformer may comprise:
a first quarter-wavelength impedance transformer in the respective first or second metal layer comprising a metal strip having a width less than a width of the respective first or second metal plate.

In one or more embodiments, the impedance transformer may comprise a second quarter-wavelength impedance transformer in the respective first or second metal layer comprising a metal strip having a width less than the width of the first quarter-wavelength impedance transformer.

In one or more embodiments, the package may comprise an output port. The output port may comprise a single-ended output in the first or second metal layer and an integrated coaxial connection.

In one or more embodiments, the singe-ended output may comprise a microstrip or a grounded co-planar waveguide.

In one or more embodiments, the integrated coaxial connection may comprise:
a central via extending from the microstrip to a third metal layer for connection to a package-to-printed circuit board, PCB, interface; and
a circular array of vias extending from the first metal layer to the third metal layer.

According to a second aspect of the present disclosure there is provided a packaged IC comprising any of the packages disclosed herein and an IC.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1A shows an example flip-chip chip-scale package;
Figure 1B shows another example flip-chip chip-scale package;
Figure 2 illustrates an example power amplifier integrated circuit design;
Figure 3 illustrates a first example package for an integrated circuit according to an embodiment of the present disclosure;
Figure 4 illustrates a second example package for an integrated circuit according to an embodiment of the present disclosure;
Figure 5 illustrates a third example package for an integrated circuit according to an embodiment of the present disclosure;
Figure 6 illustrates a top-view of a fourth example package for an integrated circuit according to an embodiment of the present disclosure;
Figure 7A illustrates a side-view of a fifth example package for an integrated circuit according to an embodiment of the present disclosure;
Figure 7B illustrates a top view of the fifth example package for an integrated circuit according to an embodiment of the present disclosure;
Figure 8A illustrates active s-parameters for a simulated example package for an integrated circuit according to an embodiment of the present disclosure;
Figure 8B illustrates insertion loss for the simulated example package for an integrated circuit according to an embodiment of the present disclosure;
Figure 9 illustrates common mode rejection for the simulated example package for an integrated circuit according to an embodiment of the present disclosure; and
Figure 10 illustrates isolation for two simulated adjacent combiners of a package for an integrated circuit according to an embodiment of the present disclosure.

### Detailed Description

High performance mm-wave interfaces are crucial for maximizing the performance of monolithic microwave integrated circuits (MMIC). A costeffective and performance-driven packaging technique to connect MMICs inputs and outputs (IOs) to a printed circuit board (PCB) can be realized by using a ball-grid-array-based (BGA) package (PKG). Examples of these packages are embedded wafer level ball grid array (eWLB), flip-chip chip-scale package (FCCSP) and flip-chip ball-grid array (FCBGA).

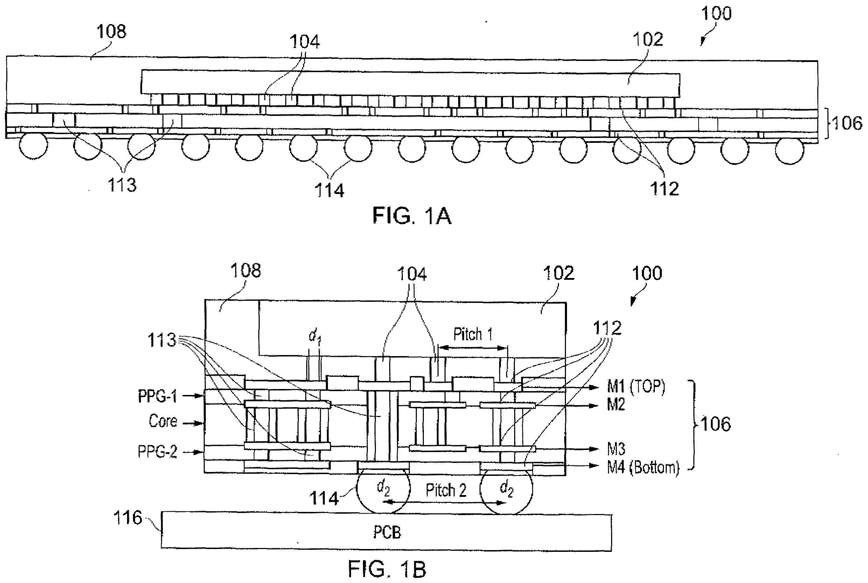

Figures 1A and 1B illustrate example FCCSP packages 100. Such package structures are known and are only described briefly here.

Die-to-package connectors 104 couple the IC / die 102 to an interposer 106 of the package 100. The die-to-package connectors 104 may comprise solder bumps (Figure 1A), so called copper pillars (Figure 1B) or vias (as may be used in embedded wafer level BGA (eWLB)). The pillars or vias may have a diameter, d₁, on the order of 100 um, for example 70 um. The die-to-package connectors 104 may be arranged in a grid array with a predetermined first pitch (labelled pitch 1) between each die-to-package connector 104. The first pitch may be on the order of 150 um. The first pitch may be defined by a manufacturer of the die-to-package connectors. The die 102 and interposer 106 may be designed with IO contacts for connecting to the die-to-package connectors 104, for example a bottom metal layer of the die 102 and a top layer of the interposer 106 may be designed to have IO connections at the pitch of the grid array to couple to the solder bumps/pillars/vias 104, The package may comprise die-to-package connectors 104 at selected positions on the grid array to correspond to the IO connections on the die/interposer.

The interposer 106 includes a plurality of metal layers 112 and can be either core based (Figure 1B) or prepreg based / coreless (Figure 1A). The interposer is typically strip-based but can also be realised on PCB-like panels (panel level packaging (PLP) to reduce cost. The example interposer 106 structure of Figure 1B will be used for reference for the present disclosure and includes four metal layers: M1 (Top), M2, M3 and M4 (Bottom). A core is defined between the second metal layer, M2, and the third metal layer, M3. A first prepreg layer, PPG-1, is defined between the first metal layer M1 and the second metal layer M2 and a second prepreg layer, PPG-2, is defined between the third metal layer, M3, and the fourth metal layer, M4. The first and second prepreg layers are bonding layers for bonding the first and fourth metal layers to the core. The first and second prepreg layers comprise a different material to the core. The package 100 comprises a plurality of vias 113 for providing connections between the different metal layers 112. The vias 113 may comprise any known via design including plated through hole vias.

An array of package-to-PCB connectors 114 connects the bottom metal layer, M4, of the Interposer 106 to the PCB 116. The package-to-PCB connectors may be arranged on a grid array with a second pitch (labelled pitch 2). The second pitch may be on the order of 500 um, for example 500um or 650 um. The package-to-PCB connectors 114 may comprise solder ball connectors and may have a diameter in the region of 300 um. The die 102 is overmolded with an overmolding 108 for reliability and protection against the environment (e.g. moisture protection).

The various types of BGA package structures provide a galvanic connection from the silicon die (MMIC) 102 to the PCB board 116, which includes two intermediate transitions:
1. Die-to-package transition (provided by die-to-package connectors 104), which connects the die 102 to package laminates, or the die 102 to a metallization layer (e.g. M1) on top of a dielectric layer (of the interposer 106). A differential implementation of the silicon circuitry is preferred, as this decreases the sensitivity of the active circuitry to external (common-mode) signals present, for example, on the PCB lines. As a consequence of the differential circuit implementation, it is logical that the transition from die to package is differential too. The die-to-package transition may also be referred to as an IC-to-package transition.
2. Package-to-PCB interface, which connects the package to the PCB using the (solder-ball) ball-grid array 114. This interface can be designed to be either differential or single-ended. In general, on the PCB it is preferred to work with single-ended signals to, for example, feed single-ended antennas. Another reason is that routing of single-ended transmission lines may be easier to accomplish than balanced differential transmission lines.

In some example automotive radar mm-wave packages, for example those operating at 77 GHz, all mm-wave interfaces are differential at the die-to-package transition and at the package-to-PCB interface. This means that an additional function to convert from balanced-to-single ended (unbalanced) signals must be added on the PCB 116. This may be referred to as a BALUN (balanced to unbalanced) function.

MMICs can be realised on a range of IC technology, including CMOS (Complementary metal-oxide-semiconductor), SiGe (silicon germanium), InP (Indium Phosphide), BiCMOS (bipolar and CMOS), GaAs (Galium Arsenide) and GaN (Galium Nitride). For MMICs, the low value of the maximum drain power voltage (Vddₘₐₓ) can result in large output stages with a large drain current to achieve a sufficient RF (radio frequency) output power level. As a result, a power amplifier (PA) with a low output impedance e.g. < 10 ohms requires an impedance transformation to ~50 ohms to enable connection to a 50 ohm load. In addition, RF energy stored in large output capacitances should be recycled.

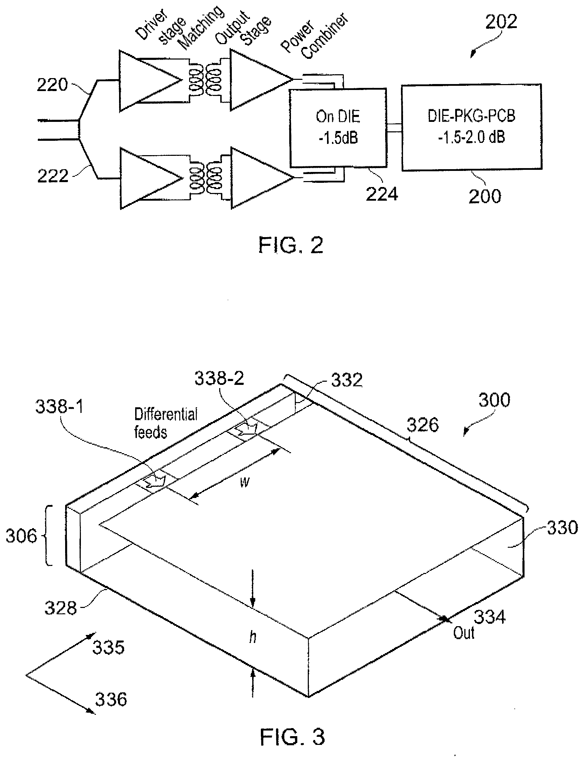

Conventional IC transformers are insufficient to handle the low impedance of the PA. Figure 2 illustrates an example PA IC design 202 that overcomes this issue by including two split branches 220, 222, each with 10 ohms output impedance. The transformer is replaced by a power combiner 224 positioned on the die (MMIC) before the connection to the package 200. The power combiner 224 may be considered as a 0.25:1 transformer. The power combiner 224 has a power loss of ~ 1.5dB and a power loss from the package 200 to the PCB is in the region of 1.5-2.0 dB providing a total loss of ~3-3.5 dB for the power combiner and package combination. In such examples, it is difficult to make the power combiner winding wide enough to get the low inductance and good Q-factor needed for efficient RF energy recycling. RF energy recycling here refers to the practice in narrowband RF circuit design to compensate the capacitive part of impedances with similar inductive parts, restoring energy which otherwise would have been lost.

Current power combiners in RF transceiver structures for mm wave applications (for example those operating at 77 GHz and 140 GHz) are typically realised on the die (MMIC) (as is the case for the example of Figure 2). Examples of such on-die combiners include Wilkinson T-splitters and transformer based combiners.

The Wilkinson combiner is a simple structure but has two major disadvantages: (i) high losses in the combiner due to long on-die transmission lines; and (ii) an increase of area required on the die and thus increased cost.

The transformer based combiner can be made low loss and compact. However, implementing a larger number of feeding points >2 as input to the combiner results in complex and long routing networks and thus higher losses and bigger area.

The present disclosure provides a package for an IC that can combine one or more differential signals to provide a single-ended output. Embodiments include an in-package power combiner that can operate with reduced loss relative to the above described combiners and can operate without a BALUN on the PCB.

Figure 3 illustrates a package 300 for an IC according to an embodiment of the present disclosure.

The package 300 includes an interposer 306 including: a first metal layer (e.g. M1) comprising a first metal plate 326; a second metal layer (e.g. M2) comprising a second metal plate 328; and a dielectric layer 330 separating the first and second metal layers. The first metal plate 326 and second metal plate 328 are arranged in parallel to form a parallel plate waveguide (PPW). The first metal plate includes a slot 332 for receiving one or more differential signals from the IC.

The PPW advantageously combines the one or more differential signals and can provide a single-ended output. In this example, the slot receives a first differential signal and a second differential signal and therefore provides an in-package (in-PKG) power combiner for combining the first and second differential signals from each amplifier branch of the IC (Figure 2). By moving the combiner from the die to the PKG, ohmic losses are reduced. The PPW can combine the first and second differential signals from the IC and guide the combined signal along a propagation direction 336 of the PPW from the slot to an output 334. The output 334 may be a single ended output 334. The PPW may guide the combined signal in one or more waveguide modes of the PPW. In some examples, the PPW may be arranged to guide the combined signal in only a fundamental transverse electromagnetic mode (TEM) as higher order modes may result in loss. The slot 332 may extend in a transverse direction 335, e.g. perpendicular, to a propagation direction 336 of the waveguide modes of, the PPW. As described below, the slot 332 may be fed or excited by a differential signal feeding structure, such as the die-to-package transition, and excite the TEM mode of the PPW to propagate the one or more differential signals to the PCB.

As the PPW comprises only two conductors, no common-mode is supported by the PPW, causing the structure to act as a BALUN circuit. In this way, the package implicitly converts the balanced signal (i.e., differential) to a single-ended output 334 and advantageously avoids the requirement of a BALUN circuit on the PCB. As also discussed below, for a plurality of differential signals, the channel count of the resulting in-package combiner is not limited to 2ⁿ and can be easily increased.

The power combiner is implemented using the PPW which may be realized using two metal layers of the interposer 306 (e.g. M1 and M2). The PPW can be excited using the slot 332 in the first metal plate 326. The slot 332 (which may be referred to as a feeding slot) may be excited using die-to-package connectors (pillars or vias) of the die-to-PKG transition.

In this example, the slot 332 of the PPW is excited by a first differential feed 338-1 for providing the first differential signal and a second differential feed 338-2 for providing the second differential signal. More generally the slot 332 can be excited by a plurality of differential feeds 338 along the length of the slot 332 in the transverse direction 335. The plurality of feeds 338 may be arranged periodically along the length of the slot. In this way, the PPW provides a plurality of combiner ports for receiving different differential signals from the IC.

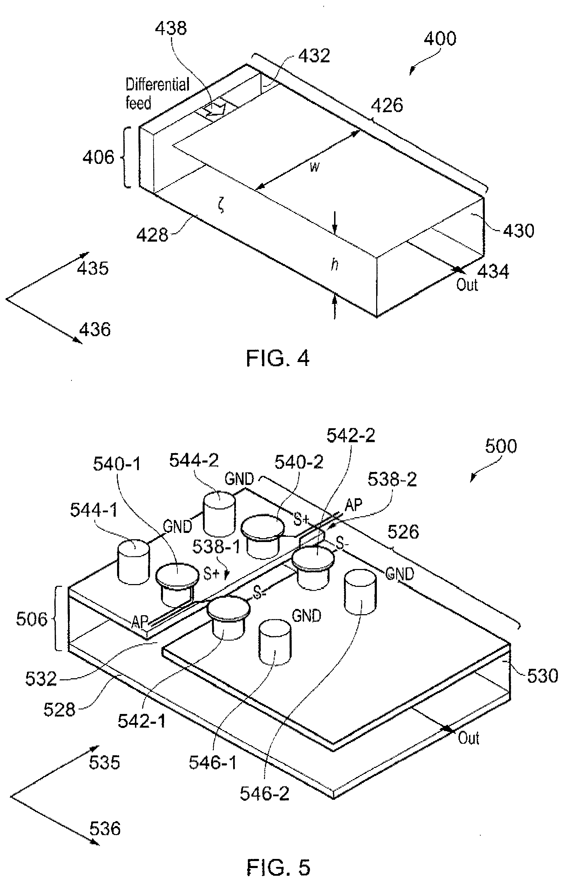

The PPW comprises the first and second metal plates 326, 328 separated by a distance, *h*. The dielectric layer 330 separating the first and second plates 326, 328 has a characteristic impedance, ξ. The impedance for each combiner port can be approximated as *Z_{act}* ≈ *ξ h*/*w*, where the width, *w*, refers to the separation of the different feeds 338. The concepts described herein may apply to two-feed packages as illustrated, to a single differential feed package (Figure 4) or to any arbitrary number of feeds (3, 4, 5, ...). The number of feeds is advantageously not limited to 2ⁿ.

Figure 4 illustrates another package 400 for an IC according to an embodiment of the present disclosure. Features of figure 4 that are present in Figure 3 have been given corresponding numbers in the 400 series and will not necessarily be described again here.

In this example, the PPW is excited by a single differential feed 438. The PPW comprises the first and second metal plates 326, 328 having a width, *w,* (perpendicular to the propagation direction) separated by a distance, *h*. The impedance of the PPW, as seen by a transverse electromagnetic wave travelling in the PPW along the propagation direction 336, is approximately *Z_{PPW}* ≈ ζ *h*/*w.* Although, this single feed example is not a power combiner (because there is only one input port), it can advantageously provide a die-to-PKG BALUN circuit.

Figures 5 illustrates a further package 500 for an IC according to an embodiment of the present disclosure. Features of figure 5 that are present in Figures 3 or 4 have been given corresponding numbers in the 500 series and will not necessarily be described again here.

In this example, the package 500 comprises a first differential feed 538-1 and a second differential feed 538-2 corresponding to two input ports of the power combiner. The first and second differential feeds 538-1, 538-2 may receive the respective first and second differential signal from the IC. Each differential feed 538-1, 538-2 comprises: a first die-to-package signal connector 540-1, 540-2 (labelled *S*+ in the figure) arranged on the first plate 526 on a first side of the slot 532; and a second die-to-package signal connector 542-1, 542-2 (labelled S- in the figure) arranged on the first plate 526 on a second side of the slot 532 opposite the first side. Each first die-to-package signal connector 540-1, 540-2 may be coupled to a corresponding first IO port of the IC that provides a first component (e.g. positive voltage component) of the corresponding first or second differential signal from a corresponding PA. Each second die-to-package signal connector 542-1, 542-2 may be coupled to a corresponding second IO port of the IC that provides a second component (e.g. negative voltage component) of the corresponding first or second differential signal from the corresponding PA. In this way, the first and second die-to-package signal connectors 540-1, 540-2, 542-1, 542-2 excite the slot 532 with the respective first or second differential signal from the corresponding PA.

In this example, the package 500 further includes die-to-package grounded connectors 544-1, 544-2, 546-1, 546-2 surrounding the first and second die-to-package signal connectors 540-1, 540-2, 542-1, 542-2. Specifically, the package 500 includes, for each differential feed 538-1, 538-2: a first die-to-package grounded connector 544-1, 544-2 arranged on the first metal plate 526 on the first side of the slot 532, wherein the first die-to-package signal connector 540-1, 540-2 is arranged between the first die-to-package grounded connector 544-1, 544-2 and the slot 532; and a second die-to-package grounded connector 546-1, 546-2 arranged on the first metal plate 526 on the second side of the slot 532, wherein the second die-to-package signal connector 542-1, 542-2 is arranged between the second die-to-package grounded connector 546-1, 546-2 and the slot 532. The die-to-package grounded connectors 544-1, 544-2, 546-1, 546-2 may be coupled to ground IO ports of the IC and may be connected to a ground IO port of the package for coupling (by traces and vias etc) to a ground connection of the PCB (by the package-to-PCB interface). The die-to-package grounded connectors 544-1, 544-2, 546-1, 546-2 and associated grounded connections may refer to a RF ground.

The first and second die-to-package signal connectors 540-1, 540-2, 542-1, 542-2, and the first and second die-to-package grounded connectors 544-1, 544-2, 546-1, 546-2 may form part of the die-to-package transition connection and may be provided as solder bumps, copper pillars or vias. In this example, the die-to-package connectors comprise metal / copper pillars.

The die-to-package grounded connectors 544-1, 544-2, 546-1, 546-2 can advantageously block an undesired waveguide mode of the PPW that may otherwise propagate between the PKG and the IC. By placing the die-to-package grounded connectors 544-1, 544-2, 546-1, 546-2, a small region between the die-to-package signal connectors 540-1, 540-2, 542-1, 542-2 and the die-to-package grounded connectors 544-1, 544-2, 546-1, 546-2 similar to a rectangular waveguide is created where the mode is in cut-off and leakage of radiation (i.e. loss) is reduced or prevented.

To reduce the pillar IO count, the die-to-package grounded connectors 544-1, 544-2, 546-1, 546-2 that provide a grounded connection in a RF regime, can also be used for the DC biasing to transistors of the PA. In such examples, the first metal layer, *M1*, on the package may correspond to the drain power voltage, *V_{dd}*, at DC, while corresponding to ground, GND, for RF operation. The die may further comprise decoupling capacitors arranged around the RF-GND/V_dd die-to-package grounded connectors 544-1, 544-2, 546-1, 546-2 to enable this dual usage of the pillars.

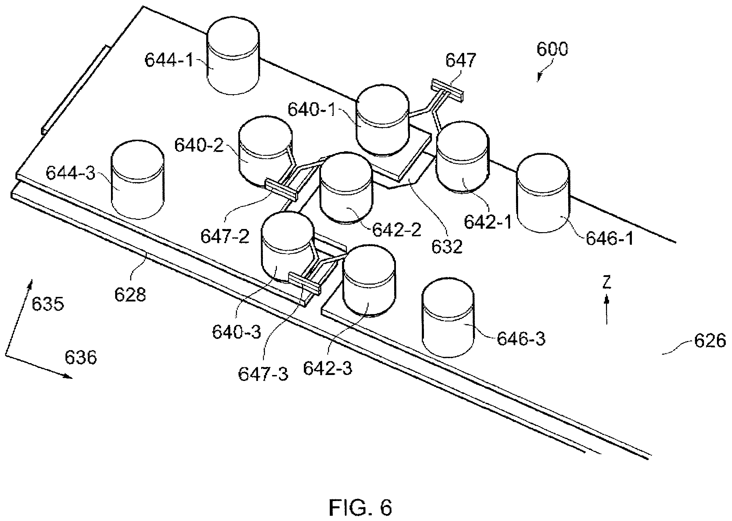

Figures 6 illustrates a perspective view of a further package 600 for an IC according to an embodiment of the present disclosure. Features of figure 6 that are present in Figures 3, 4 or 5 have been given corresponding numbers in the 600 series and will not necessarily be described again here.

This example includes a three-way combiner (three differential feeds / signals). A first port of the combiner comprises: a first differential feed comprising first and second die-to-package signal connectors 640-1, 642-1; and first and second die-to-package grounded connectors 644-1, 646-1. A second signal port of the combiner comprises a second differential feed comprising first and second die-to-package signal connectors 640-2, 642-2 (and no die-to-package grounded connectors). A third port of the combiner comprises: a third differential feed comprising first and second die-to-package signal connectors 640-3, 642-3; and first and second die-to-package grounded connectors 644-3, 646-3.

In this example, the slot 632 in the first metal plate 626 traverses the PPW with a meandering shape allowing for a more compact solution. Specifically, the slot 632 comprises first portions (corresponding to the first and third combiner ports) at which the slot traverses the PPW along the transverse direction 635 at a first position with respect to the propagation direction 636. The slot comprises second portions (corresponding to the second combiner port) at which the slot 632 traverses the PPW along the transverse direction 635 at a second position with respect to the propagation direction. The first and second portions of the slot 632 are connected by third portions of the slot 632 which run parallel to the propagation direction 636.

As a result of the meandering shape, the die-to-package grounded connectors 644-1, 646-1, 644-3, 646-3 are arranged at the corners of the meandering slot 632 to block the undesired PPW mode. The die-to-package signal connectors 640-1, 642-1, 640-2, 642-2, 640-3, 642-3 are arranged close to the slot 632. The final stages of the corresponding PAs may also be arranged close to the slot 632.

In this example, differential signal IO connections 647-1, 647-2, 647-3 of the die are illustrated that connect to the die-to-package signal connectors 640-1, 642-1, 640-2, 642-2, 640-3, 642-3.

In this example, the GND plane on the die may be interrupted around the die-to-package grounded connectors 644-1, 646-1, 644-3, 646-3. The die-to-package grounded connectors 644-1, 646-1, 644-3, 646-3 may be connected to the GND plane on the die via the decoupling capacitors mentioned above.

Since there are only two conductors, no common-mode is supported by the PPW, causing the structure to act as a BALUN circuit. From the PPW, impedance transformers can be added to transform to a single ended output (e.g. a microstrip line) for convenient connection with e.g. a transition to a printed circuit board (PCB). The PPW can be tapered to a microstrip in the package which can be further routed so that the signal exits the package to the PCB.

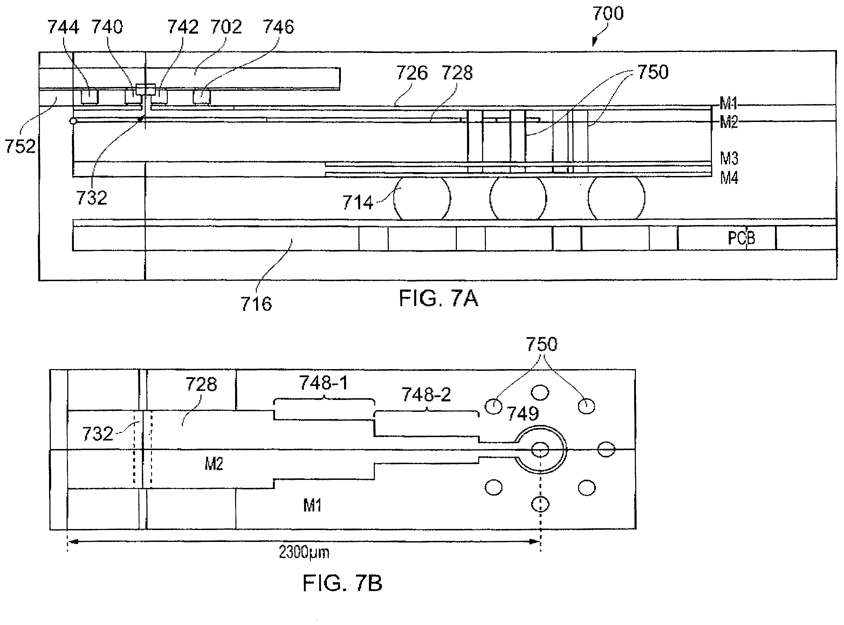

Figures 7A and 76 respectively illustrate a side-view and a top-view of another example package for an IC according to an embodiment of the present disclosure. Features of figure 7 that are present in Figures 3, 4, 5 or 6 have been given corresponding numbers in the 700 series and will not necessarily be described again here.

As in previous examples, the package 700 includes a first metal layer M1 comprising a first metal plate 726 and second metal layer M2 comprising a second metal plate 728. The first metal plate 726 and the second metal plate 728 form a PPW. The first metal plate 726 includes a slot 732 for receiving one or more differential signals from the IC 702. The slot is excited by first and second die-to-package signal connectors 740, 742 of the die-to-package transition (copper pillars), each placed on a different side of the slot 732. First and second die-to-package grounded connectors 744, 746 of the die-to-package transition are placed around the first and second die-to-package signal connectors 740, 742. The die-to-package grounded connectors 744, 746 advantageously avoid excitation of an undesired mode between the ground plane on the IC and the first metal layer, M1, on the package 700.

In this example, a non-propagating end of the PPW is terminated using an open-ended stub. A distance from the slot 732 to the open-ended stub 752 may be a quarter-wavelength (of a centre operating wavelength of the IC) to provide a reflection from the open-ended stub 752. In other examples, a short circuit connection may be used instead of the open-ended stub 752. The open-ended stub 752 or short circuit advantageously avoid a 3dB loss due to signals propagating in the wrong direction along the PPW.

In this example an impedance transformer of the package 700 is also illustrated. The impedance transformer can provide a transition from the PPW to a microstrip line for onward connection, e.g. to a package-to-PCB interface and onward to a load on the PCB 716. The impedance transformer comprises a tapering from the PPW to a microstrip 749 for outputting the signal. In other examples, a different single-ended output structure may be used, for example a grounded co-planar waveguide. In this example, the impedance transformer comprises a first quarter-wavelength impedance transformer 748-1 and a second quarter-wavelength impedance transformer 748-2. In this example the first and second quarter-wavelength impedance transformer 748-2 are realized in the second metal layer, M2, however in other examples they may be realized in the first metal layer, M1, or a different metal layer. The microstrip 749 may be realized in the same metal layer as the impedance transformer. The first and second quarter-wavelength impedance transformers 748-1, 748-2 provide a step-wise tapering. The first quarter-wavelength impedance transformer 748-1 comprises a first width (in the transverse direction) narrower than a width of the (second plate 728 of the) PPW. The second quarter-wavelength impedance transformer 748-2 comprises a second width less than the first width. The first and second quarter-wavelength impedance transformers 748-1, 748-2 have a fixed length which corresponds to a quarter wavelength for a centre wavelength of operation. The impedance transformer can transform the impedance from a low impedance of a multi-feed PPW (~5 ohms) towards the impedance of a load on the PCB (e.g. an antenna (~50 ohms)). In some examples, the impedance transformer may have more or less quarter-wavelength transformers, for example a single quarter-wavelength transformer, depending on output load, among otherthings. Providing multiple quarter-wavelength transformers can enlarge a bandwidth of the package.

In this example an integrated coaxial connection 750 is also illustrated. The integrated coaxial connection comprises: (i) a central via extending from the microstrip 749 to a third metal layer (which may be the bottom metal layer, M4) for connection to the package-to-PCB interface/transition, which in this example is provided by solder balls 714; and (ii) a circular array of vias extending from the first metal layer to the third metal layer. The circular array of vias act as an outer conductor of the integrated coaxial connection. The integrated coaxial connection can transfer the signal from the microstrip to M4 for transfer to the PCB 716 by a solder ball 714. The solder ball 714 may be connected to a grounded coplanar waveguide line on the PCB 716, which may be connected, for example, to a radiating structure.

The illustrated example design of Figure 7 provides an in-package PPW power combiner which includes the transition from the die 702 to the top of the package 700 using copper pillars 740, 742, the PPW power combiner, an impedance transformer 748-1, 748-1, an integrated coaxial connection 750 to the bottom metal layer, M4, of the package 700 and a solder ball connection 714 to the PCB 716. The total size of the structure on the package, from the back of the open-ended stub 752 to the integrated coaxial connection 750, is equal to 2300µm (similar to a Balun structure at ~100 GHz).

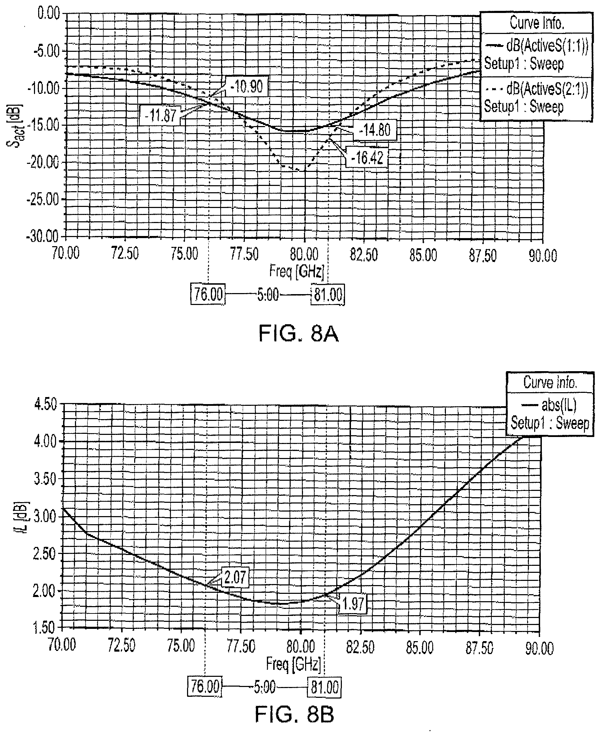

Figures 8A and 8B illustrate simulation results for a packaged IC according to an embodiment of the present disclosure. The simulated package comprises two input ports on the IC (that excited two differential feeds to the slot) and an output port on the PCB (coupled to a single ended output port of the package).

The active S-parameters (S_act) of the two input ports on the IC are shown in Figure 8A. The insertion losses are shown in Figure 8B. The Figures illustrate that the combiner is well matched (S_act<-10dB) in the frequency band of interest, 76 to 81 GHz, and that the insertion losses are approximately 2dB (significantly lower than the 3-3.5dB mentioned in relation to the structure of Figure 1).

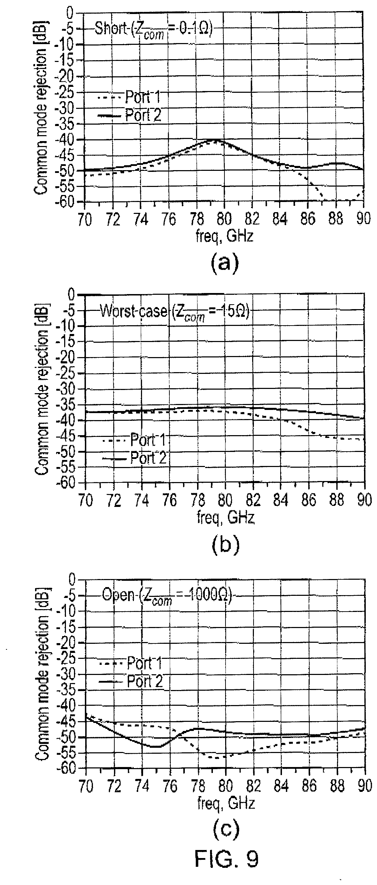

Figures 9 shows simulated common mode rejection for the simulated in-PKG PPW combiner (including the transition to the PCB) described in relation to Figures 8A and 8B. Three plots are illustrated. A first plot, (a), illustrates rejection for a common mode impedance on the die to be shorted, *Z_{com}* = 0.1Ω. A second plot, (b) shows a worst case scenario - a common mode impedance, *Z_{com}* = 15Ω. A third plot, (c), shows the common mode impedance to be open circuit, *Z_{com}* = 1000Ω. Plot (b) illustrates a worst case common mode rejection of -35dB. If the common mode impedance is considered high, i.e. 1000Ω, values lower than -45dB are shown over the entire band of interest.

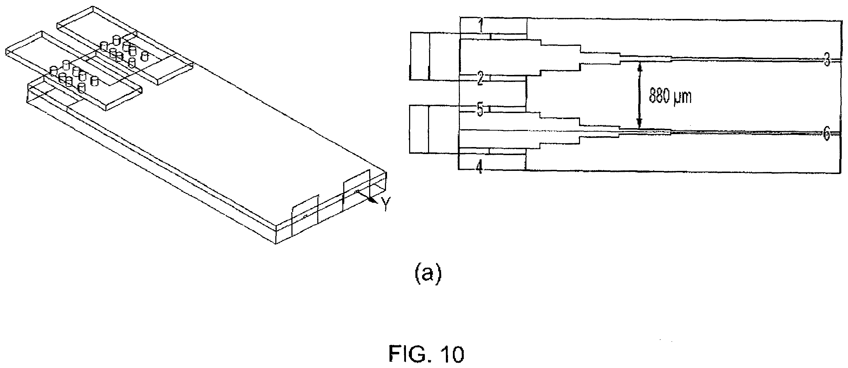

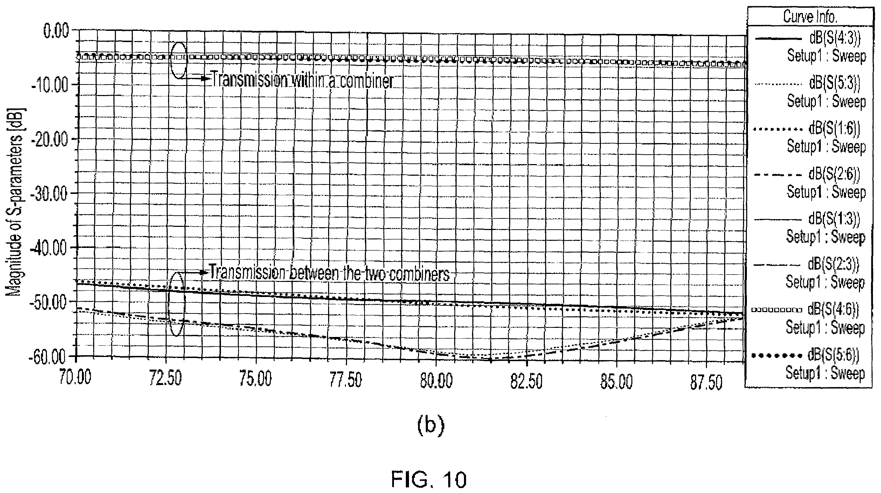

Figure 10 shows simulation results for the isolation between two adjacent in-package combiners, such as those described in relation to Figures 3 to 7, The upper part, (a), of Figure 10 shows the simulated structure. A simplified structure was considered, excluding the integrated coaxial transitions in the package and to the PCB, so as to only simulate the effect of the feeding slots and the two PPWs. The two simulated combiners were implemented in a single package and the grounds of the microstrips on M1 were connected. The distance between the two combiners considered in this example was 880µm.

The lower part, (b), of Figure 10 illustrates an isolation between the two combiners lower than -45dB in the entire frequency band of interest.

This present disclosure provides a package for combination of one or more differential signals to provide a single-ended output. Embodiments include an in package (PKG) waveguide power combiner for combining a plurality of differential signals and can be used for 77 GHz and 140 GHz radar applications. The in package combiner may be implemented in mm Wave packages for consumer, industrial, communication (e.g., 5G), and automotive (e.g. auto radar) applications.

In some examples, dimensions of the in-PKG power combiner (e.g. first and second plate width, slot width, signal connector position/pitch, grounded connector position / pitch, differential feed spacing) can be selected to advantageously control an imaginary part of the impedance of the package/combiner to provide a good Q-factor and energy recycling (compensating any parasitic capacitances). The many structural dimensions of the in-PKG combiner advantageously provide many degrees of freedom making it easier to optimise the imaginary impedance and provide energy recycling compared to conventional on-die combiners.

The disclosed packages can combine all differential input voltage components supplied from the IC into a single output voltage component, the single ended output signal, to be delivered to the PCB.

As described herein, a differential signal may comprise a first component and a second component. The first component may comprise a first voltage component and the second component may comprise a second voltage component. The first voltage component may comprise a positive voltage component and the second voltage component may comprise a negative voltage component. As an example the first voltage component could be alternating with a frequency, e.g. 78 GHz, while the second voltage component would have the same frequency and magnitude, but have an opposite phase.

Although the disclosed package has been described in relation to receiving one or more differential inputs from an IC and providing a combined output, it will be appreciated that the disclosed structure may also operate in reverse. In other words the package could be used as a transition from PCB to die, with a power splitting functionality. Therefore, although the slot is suitable for receiving one or more differential signals from the IC, it is also suitable for providing one or more differential signals to the IC based on a single-ended input received from the PCB and coupled to the PPW. In other words, the slot is suitable for coupling one or more differential signals to and/or from the IC.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments,

## Claims

1. A package for an integrated circuit, IC, the package comprising an interposer comprising:
a first metal layer including a first metal plate;
a second metal layer including a second metal plate; and
a dielectric layer separating the first metal layer and the second metal layer,
wherein the first metal plate and the second metal plate are arranged to form a parallel plate waveguide, PPW, and wherein the first metal plate comprises a slot for receiving one or more differential signals from the IC.

2. The package of claim 1, wherein the PPW is configured to combine the one or more differential signals and provide an output signal.

3. The package of claim 1 or claim 2, wherein the package further comprises one or more differential feeds for receiving a respective one of the one or more differential signals, wherein each differential feed is arranged to excite the slot and the PPW in response to receiving the respective differential signal.

4. The package of claim 3, wherein the one or more differential feeds comprise a plurality of differential feeds spaced apart along a length of the slot.

5. The package of claim 3 or claim 4, wherein the one or more differential feeds form part of an IC-to-package transition connection.

6. The package of any of claims 3 to 5, wherein each differential feed comprises:
a first die-to-package signal connector arranged on the first plate on a first side of the slot; and
a second die-to-package signal connector arranged on the first plate on a second side of the slot opposite the first side.

7. The package of claim 6, wherein the package comprises:
a first die-to-package grounded connector arranged on the first metal plate on the first side of the slot, wherein a first die-to-package signal connector of a first differential feed is arranged between the first die-to-package grounded connector and the slot; and
a second die-to-package grounded connector arranged on the first metal plate on the second side of the slot, wherein the second die-to-package signal connector of the first differential feed is arranged between the second die-to-package grounded connector and the slot.

8. The package of any of claims 3 to 7, wherein the package comprises a plurality of die-to-package grounded connectors arranged further from the slot than the one or more differential feeds.

9. The package of any preceding claim, wherein the slot traverses the first metal plate with a meandering shape.

10. The package of claim 9, wherein the PPW extends in a propagation direction from the slot to an output port of the PPW and wherein the slot comprises:
a first portion extending in a transverse direction, perpendicular to the propagation direction, at a first position with respect to the propagation direction;
a second portion extending in the transverse direction at a second position with respect to the propagation direction, wherein the second position is offset from the first position;
a third portion extending in the propagation direction and connecting the first portion and the second portion.

11. The package of any preceding claim, wherein a non-propagating end of the PPW comprises an open-ended stub or a short circuit connection.

12. The package of any preceding claim, wherein the package comprises an impedance transformer extending between the PPW and an output port of the package.

13. The package of claim 12, wherein the impedance transformer is realised in the first metal layer or the second metal layer and the impedance transformer comprises:
a first quarter-wavelength impedance transformer in the respective first or second metal layer comprising a metal strip having a width less than a width of the respective first or second metal plate.

14. The package of any preceding claim, wherein the package comprises an output port, wherein the output port comprises a single-ended output in the first or second metal layer and an integrated coaxial connection.

15. A packaged IC comprising the package of any preceding claim and an IC.

## Amended claims

### Amended claims in accordance with Rule 137(2) EPC.

1. A package for an integrated circuit, IC, the package comprising an interposer comprising:
a first metal layer including a first metal plate;
a second metal layer including a second metal plate; and
a dielectric layer separating the first metal layer and the second metal layer,
wherein the first metal plate and the second metal plate are arranged to form a parallel plate waveguide, PPW, and wherein the first metal plate comprises a slot for receiving one or more differential signals from the IC;
wherein the package further comprises one or more differential feeds for receiving a respective one of the one or more differential signals, wherein each differential feed is arranged to excite the slot and the PPW in response to receiving the respective differential signal, wherein the one or more differential feeds comprise a plurality of differential feeds spaced apart along a length of the slot.

2. The package of claim 1, wherein the PPW is configured to combine the one or more differential signals and provide an output signal.

3. The package of any preceding claim, wherein the one or more differential feeds form part of an IC-to-package transition connection.

4. The package of any preceding claim, wherein each differential feed comprises:
a first die-to-package signal connector arranged on the first plate on a first side of the slot; and
a second die-to-package signal connector arranged on the first plate on a second side of the slot opposite the first side.

5. The package of claim 4, wherein the package comprises:
a first die-to-package grounded connector arranged on the first metal plate on the first side of the slot, wherein a first die-to-package signal connector of a first differential feed is arranged between the first die-to-package grounded connector and the slot; and
a second die-to-package grounded connector arranged on the first metal plate on the second side of the slot, wherein the second die-to-package signal connector of the first differential feed is arranged between the second die-to-package grounded connector and the slot.

6. The package of any preceding claim, wherein the package comprises a plurality of die-to-package grounded connectors arranged further from the slot than the one or more differential feeds.

7. The package of any preceding claim, wherein the slot traverses the first metal plate with a meandering shape.

8. The package of claim 7, wherein the PPW extends in a propagation direction from the slot to an output port of the PPW and wherein the slot comprises:
a first portion extending in a transverse direction, perpendicular to the propagation direction, at a first position with respect to the propagation direction;
a second portion extending in the transverse direction at a second position with respect to the propagation direction, wherein the second position is offset from the first position;
a third portion extending in the propagation direction and connecting the first portion and the second portion.

9. The package of any preceding claim, wherein a non-propagating end of the PPW comprises an open-ended stub or a short circuit connection.

10. The package of any preceding claim, wherein the package comprises an impedance transformer extending between the PPW and an output port of the package.

11. The package of claim 10, wherein the impedance transformer is realised in the first metal layer or the second metal layer and the impedance transformer comprises:
a first quarter-wavelength impedance transformer in the respective first or second metal layer comprising a metal strip having a width less than a width of the respective first or second metal plate.

12. The package of any preceding claim, wherein the package comprises an output port, wherein the output port comprises a single-ended output in the first or second metal layer and an integrated coaxial connection.

13. A packaged IC comprising the package of any preceding claim and an IC.
